(19) **Europäisches Patentamt European Patent Office Office européen des brevets**

(11) **EP 4 726 315 A1**

(12) # EUROPEAN PATENT APPLICATION
published in accordance with Art. 153(4) EPC

(43) Date of publication:
**15.04.2026 Bulletin 2026/16**

(21) Application number: **24864328.0**

(22) Date of filing: **07.08.2024**

(51) International Patent Classification (IPC):
**F28D 15/04** (2006.01)    **F28D 15/02** (2006.01)

(52) Cooperative Patent Classification (CPC):
**F28D 15/046; F28D 15/02; F28D 15/04; H10W 40/73;** F28D 15/0233; F28F 1/30; H10W 40/226

(86) International application number:
**PCT/CN2024/110412**

(87) International publication number:
**WO 2025/055605 (20.03.2025 Gazette 2025/12)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **12.09.2023 CN 202311171404**

(71) Applicant: **Honor Device Co., Ltd. Shenzhen, Guangdong 518040 (CN)**

(72) Inventors:
- **ZHOU, Haozu**
  **Shenzhen, Guangdong 518040 (CN)**
- **QU, Xide**
  **Shenzhen, Guangdong 518040 (CN)**
- **SUN, Guiping**
  **Shenzhen, Guangdong 518040 (CN)**
- **YANG, Yuanru**
  **Shenzhen, Guangdong 518040 (CN)**

(74) Representative: **MERH-IP Matias Erny Reichl Hoffmann Patentanwälte PartG mbB Paul-Heyse-Straße 29 80336 München (DE)**

(54) **HEAT PIPE, HEAT DISSIPATION DEVICE, AND ELECTRONIC DEVICE**

(57) This application discloses a heat pipe, a heat sink, and an electronic device, where the heat pipe includes a pipe body, a first capillary structure, and a second capillary structure. The pipe body has an accommodation cavity therein, and the accommodation cavity is configured to seal a working fluid. The first capillary structure is attached to an inner pipe surface of the pipe body. The second capillary structure is wrapped inside the first capillary structure. According to the heat pipe in this application, the first capillary structure having a relatively large capillary pressure wraps the second capillary structure having a relatively large permeability, so that a composite capillary structure having a high-speed backflow channel is formed in the heat pipe. Therefore, advantages of different capillary structures are fully utilized, so that the working fluid in the heat pipe rapidly and fully participates in cyclic heat transfer in a liquid-vapor phase change, thereby improving heat transfer performance of the heat pipe.

FIG. 7

EP 4 726 315 A1

**Description**

This application claims priority to Chinese Patent Application No. 202311171404.2, filed with the China National Intellectual Property Administration on September 12, 2023 and entitled "HEAT PIPE, HEAT SINK, AND ELECTRONIC DEVICE", which is incorporated herein by reference in its entirety.

**TECHNICAL FIELD**

This application relates to the field of heat pipe technologies, and in particular, to a heat pipe, a heat sink, and an electronic device.

**BACKGROUND**

As electronic devices gradually develop toward miniaturization, lightness and thinness, and high performance, integration of an electronic element in the electronic device is also increasingly high, accompanied by increasingly high power consumption. How to rapidly and effectively dissipate heat generated by the electronic element is a key problem to be resolved in development of the electronic device toward miniaturization, lightness and thinness, and high performance.

A heat pipe (Heat pipe) is a heat transfer element that rapidly transfers heat by using a liquid-vapor phase change, and is widely used in the cooling field of an electronic element with a high power density. The heat pipe has a capillary structure therein for performing cyclic heat transfer. Capillary performance of the capillary structure represents heat transfer performance of the heat pipe. Better capillary performance indicates a stronger heat transfer capability of the heat pipe.

When capillary performance of the capillary structure is evaluated, a capillary pressure and a permeability are two most important parameters. How to balance a relationship between the capillary pressure and the permeability, so that the capillary structure can achieve a large permeability while having a relatively large capillary pressure, to reduce liquid backflow resistance, is the key to improving heat transfer performance of the heat pipe.

SUMMARY

An objective of this application is to provide a heat pipe, a heat sink, and an electronic device. A first capillary structure having a relatively large capillary pressure wraps a second capillary structure having a relatively large permeability, to fully utilize a large driving force generated by the first capillary structure and a low-resistance backflow channel established by the second capillary structure, so that a working fluid in the heat pipe can rapidly and fully participate in cyclic heat transfer working in a liquid-vapor phase change, thereby improving heat transfer performance of the heat pipe.

According to a first aspect, this application provides a heat pipe, including a pipe body, a first capillary structure, and a second capillary structure.

The pipe body has an accommodation cavity therein, and the accommodation cavity is configured to seal a working fluid.

The first capillary structure is attached to an inner pipe surface of the pipe body. The second capillary structure is wrapped inside the first capillary structure.

A proper material is selected to form a preset relationship between capillary pressures of the first capillary structure and the second capillary structure and between permeabilities thereof: The capillary pressure of the first capillary structure is greater than the capillary pressure of the second capillary structure, and the permeability of the second capillary structure is greater than the permeability of the first capillary structure.

According to the heat pipe provided in this application, a material with a relatively large capillary pressure is selected for the first capillary structure, and a material with a relatively large permeability is selected for the second capillary structure. In addition, because the second capillary structure is wrapped inside the first capillary structure and is not exposed to the accommodation cavity, an inner surface of the accommodation cavity is entirely the first capillary structure. Because the capillary pressure is a surface parameter, the capillary pressure in the heat pipe is entirely from the first capillary structure. Based on this case, driven by the relatively large capillary pressure of the first capillary structure, the liquid-phase working fluid flows back by using the two channels, namely, both the first capillary structure and the second capillary structure. The second capillary structure with low backflow resistance is used as a "high-speed channel" for the liquid-phase working fluid to flow back. Therefore, the liquid-phase working fluid can be rapidly transported to an evaporation part. Compared with a heat pipe that is provided only with a first capillary structure, the heat pipe in this application has smaller backflow resistance. Compared with a heat pipe that is provided only with a second capillary structure, the heat pipe in this application has a larger driving force. Therefore, a design manner in which the first capillary structure wraps the second capillary structure is used, so that the heat pipe in this application facilitates backflow of the liquid-phase working fluid, and accelerates a liquid-vapor phase circulation speed. Therefore, a heat transfer capability of the heat pipe can be improved, to effectively avoid dry-out at the evaporation part and liquid aggregation at the condensation part, so that the heat pipe is not prone to reach a heat transfer limit.

In addition, because the liquid-phase working fluid can flow back to the evaporation part along the second capillary structure, the liquid-phase working fluid does not conflict with the vapor-phase working fluid in the accommodation cavity, thereby isolating the vapor-phase working fluid from the liquid-phase working fluid. Therefore, counterflow interference between the vapor-phase working fluid and the liquid-phase working fluid that flows back is avoided, so that liquid-vapor phase change cycling in the heat pipe is smoother.

In addition, because the liquid-phase working fluid at the condensation part can be rapidly transported back to the evaporation part, liquid aggregation at the condensation part can be avoided, thereby effectively avoiding an abnormal noise problem, and improving user experience. A specific reason is as follows: For the heat pipe in a related technology, due to a design defect in the capillary structure of the heat pipe, the liquid-phase working fluid has difficulty in flowing back, and a large amount of liquid is prone to aggregate at the condensation part. When the heat pipe or the electronic device is reversed, the large amount of liquid aggregated at the condensation part impacts an inner wall of the heat pipe and produces dripping noise, which affects user experience.

In a possible design, the first capillary structure includes at least one of a metal powder sintered body, a non-metal powder sintered body, and a metal braided mesh. The materials used for the first capillary structure mostly have a small pore size inside and have a relatively large capillary pressure as a whole, which can provide a larger driving force for vapor-liquid circulation in the heat pipe.

In a possible design, the second capillary structure includes at least one of a metal foam, a non-metal fiber body, a metal braided mesh, and a metal braid. The materials used for the second capillary structure mostly have a relatively large pore size inside and have a relatively large permeability as a whole, so that flow resistance of the liquid-phase working fluid in a circulation process can be reduced.

In a possible design, the heat pipe further includes a groove capillary structure, disposed on the inner pipe surface and/or the second capillary structure. The additionally disposed groove capillary structure can further improve the permeability inside the entire heat pipe, thereby further reducing backflow resistance of the liquid-phase working fluid.

In a possible design, a side that is of the second capillary structure and that faces the inner pipe surface is exposed from the first capillary structure and abuts against the inner pipe surface. In this way, a side of the second capillary structure has a support surface, to facilitate positioning of the second capillary structure, and facilitate implementation and manufacturing.

In a possible design, there are a plurality of second capillary structures, and the plurality of second capillary structures are disposed at intervals in a circumferential direction of the pipe body. The plurality of second capillary structures disposed at intervals may further improve a backflow speed of the liquid-phase working fluid, thereby improving a heat transfer capability of the heat pipe.

In a possible design, a part that is of the first capillary structure and that corresponds to the second capillary structure has a protrusion part. The protrusion part is provided to make the part that is of the first capillary structure and that corresponds to the second capillary structure have a sufficient thickness, so that the first capillary structure can have enough wrapping and fastening strength for the second capillary structure, and the second capillary structure is prevented from easily falling off because the part is excessively thin. This improves vibration resistance of the heat pipe, and can also ensure structural stability of the first capillary structure and the second capillary structure during severe vibration, thereby improving reliability of the heat pipe.

In a possible design, an edge of the protrusion part is smoothly transitioned to a surface of the first capillary structure. A sharp corner that interferes with flow of airflow is avoided at the protrusion part. When the vapor-phase working fluid at the evaporation part flows to the condensation part, the protrusion part in this embodiment can reduce a blocking effect on the vapor-phase working fluid, so that the vapor-phase working fluid can also rapidly flow to the condensation part. This also accelerates a liquid-vapor phase circulation speed, and can improve a heat transfer capability of the heat pipe. Therefore, the heat pipe has good temperature uniformity between cold and hot ends, so that the heat pipe is not prone reach a heat transfer limit.

In a possible design, the pipe body includes two opposite flat pipe walls and two opposite curved pipe walls. A flat heat pipe may be applied to an electronic device with a thickness limit, so that the heat pipe can meet a design requirement of lightness and thinness.

In a possible design, the first capillary structure and the second capillary structure are disposed on either of the two flat pipe walls. When the heat pipe is flat, only a flat pipe wall on a side facing a thermally conductive plate is actually used to be in contact with an electronic element for heat exchange. Therefore, the first capillary structure and the second capillary structure may be disposed only on the flat pipe wall. This can reduce material costs used to manufacture the capillary structure.

In a possible design, the first capillary structure is disposed in a circle around the inner pipe surface in the circumferential direction of the pipe body.

In a possible design, an interval distance between two adjacent second capillary structures is 2-4 mm.

In a possible design, a distance from a surface of the protrusion part to the second capillary structure is greater than 0.3 mm.

In a possible design, a thickness of the second capillary structure is 0.2-0.7 mm.

In a possible design, a width of the second capillary structure is 2-8 mm.

In a possible design, a thickness of the first capillary structure is 0.4-1.1 mm.

In a possible design, a material of the non-metal fiber body includes glass fiber or carbon fiber.

In a possible design, a material of the metal foam includes copper or aluminum, a material of the metal braided mesh includes copper or aluminum, and a material of the metal braid includes copper or aluminum.

According to a second aspect, this application further provides a heat sink, including a heat dissipation assembly, a thermally conductive plate, and the heat pipe according to any one of the foregoing, where the heat dissipation assembly is sleeved on a condensation part of the heat pipe, and the thermally conductive plate is fastened to an evaporation part of the heat pipe.

The heat sink in this application includes the foregoing heat pipe. Inside the heat pipe, a material with a relatively large capillary pressure is selected for the first capillary structure, and a material with a relatively large permeability is selected for the second capillary structure. In addition, because the second capillary structure is wrapped inside the first capillary structure and is not exposed to the accommodation cavity, an inner surface of the accommodation cavity is entirely the first capillary structure. Because the capillary pressure is a surface parameter, the capillary pressure in the heat pipe is entirely from the first capillary structure. Based on this case, driven by the relatively large capillary pressure of the first capillary structure, the liquid-phase working fluid flows back by using the two channels, namely, both the first capillary structure and the second capillary structure. The second capillary structure with low backflow resistance is used as a "high-speed channel" for the liquid-phase working fluid to flow back. Therefore, the liquid-phase working fluid can be rapidly transported to an evaporation part. Compared with a heat pipe that is provided only with a first capillary structure, the heat pipe in this application has smaller backflow resistance. Compared with a heat pipe that is provided only with a second capillary structure, the heat pipe in this application has a larger driving force. Therefore, a design manner in which the first capillary structure wraps the second capillary structure is used, so that the heat pipe in this application facilitates backflow of the liquid-phase working fluid, and accelerates a liquid-vapor phase circulation speed. Therefore, a heat transfer capability of the heat pipe can be improved, to effectively avoid dry-out at the evaporation part and liquid aggregation at the condensation part, so that the heat pipe is not prone to reach a heat transfer limit. This can effectively improve a heat dissipation power of the heat sink.

According to a third aspect, this application further provides an electronic device, including the foregoing heat sink.

The electronic device may be any one of a notebook computer, a desktop computer, a tablet computer, a game console, a mobile phone, an electronic watch, a router, a set-top box, a television, and a modem.

## BRIEF DESCRIPTION OF DRAWINGS

FIG. 1 is a schematic diagram of a heat pipe heat sink in a related technology;
FIG. 2 is a sectional view taken along A-A in FIG. 1;
FIG. 3 is a sectional view taken along B-B in FIG. 1;
FIG. 4 is a longitudinal sectional view of a heat pipe according to an embodiment of this application;
FIG. 5 is a schematic diagram of a working principle of a heat pipe according to an embodiment of this application;
FIG. 6 is a cross-sectional view of a first example of a heat pipe according to an embodiment of this application;
FIG. 7 is a cross-sectional view of a second example of a heat pipe according to an embodiment of this application;
FIG. 8 is a cross-sectional view of a third example of a heat pipe according to an embodiment of this application;
FIG. 9 is a cross-sectional view of a fourth example of a heat pipe according to an embodiment of this application;
FIG. 10 is a cross-sectional view of a fifth example of a heat pipe according to an embodiment of this application;
FIG. 11 is a cross-sectional view of a sixth example of a heat pipe according to an embodiment of this application;
FIG. 12 is a cross-sectional view of a seventh example of a heat pipe according to an embodiment of this application;
FIG. 13 is a cross-sectional view of an eighth example of a heat pipe according to an embodiment of this application;
FIG. 14 is a cross-sectional view of a ninth example of a heat pipe according to an embodiment of this application;
FIG. 15 is a cross-sectional view of a tenth example of a heat pipe according to an embodiment of this application;
FIG. 16 is a cross-sectional view of an eleventh example of a heat pipe according to an embodiment of this application;
FIG. 17 is a cross-sectional view of a twelfth example of a heat pipe according to an embodiment of this application;
FIG. 18 is a cross-sectional view of a thirteenth example of a heat pipe according to an embodiment of this application;
FIG. 19 is a cross-sectional view of a fourteenth example of a heat pipe according to an embodiment of this application;

FIG. 20 is a cross-sectional view of a fifteenth example of a heat pipe according to an embodiment of this application;

FIG. 21 is a cross-sectional view of a sixteenth example of a heat pipe according to an embodiment of this application;

FIG. 22 is a cross-sectional view of a seventeenth example of a heat pipe according to an embodiment of this application;

FIG. 23 is a cross-sectional view of an eighteenth example of a heat pipe according to an embodiment of this application;

FIG. 24 is a cross-sectional view of a nineteenth example of a heat pipe according to an embodiment of this application; and

FIG. 25 is a schematic diagram of an electronic device according to an embodiment of this application.

Reference numerals:

10. pipe body; 11. accommodation cavity; 12. inner pipe surface; 13. flat pipe wall; 14. curved pipe wall; 20. first capillary structure; 21. protrusion part; 30. second capillary structure; 40. groove capillary structure;

51. metal powder sintered body; 52. metal braided mesh; 53. metal foam; 54. non-metal fiber body; 55. metal braid; 56. non-metal powder sintered body;

100. heat pipe; 101. evaporation part; 102. condensation part; 103. capillary structure; 200. heat dissipation assembly; 300. thermally conductive plate; 400. heat sink; 500. electronic element.

## DESCRIPTION OF EMBODIMENTS

The following describes possible related content in embodiments of this application by using examples. Clearly, the described embodiments are merely some rather than all of the embodiments of this application.

In the descriptions of this application, it should be noted that, unless otherwise specified and limited, the terms "mount", "connection", and "connect" should be understood in a broad sense, for example, may indicate a fixed connection, a detachable connection, or an integral connection; may be a mechanical connection, an electrical connection, or mutual communication; may be a direct connection, or an indirect connection through an intermediate medium; or may be an internal connection between two elements or an interaction relationship between two elements. A person of ordinary skill in the art may understand specific meanings of the foregoing terms in this application based on specific cases.

In the descriptions of this application, it should be understood that an orientation relationship or a position relationship indicated by terms "up", "down", "side", "in", "out", "top", and "bottom" are an orientation relationship or a position relationship based on mounting, and is merely for ease of description and simplification of this application, but is not intended to indicate or imply that a specified apparatus or element necessarily has a specific orientation or is constructed and operated in a specific orientation. Therefore, the terms should not be construed as a limitation on this application.

It should be further noted that in the embodiments of this application, a same reference numeral indicates a same component part or a same part. For a same part in this embodiment of this application, only one part or component may be used as an example in the figure to mark a reference numeral. It should be understood that, for another same part or component, the reference numeral is also applicable.

In the description of this application, it should be noted that term "and/or" is only used to describe an association relationship between associated objects, and indicates that three relationships may exist. For example, A and/or B may indicate the following: Only A exists, both A and B exist, and only B exists.

An electronic element is a basic element in an electronic circuit, and has two or more leads or metal contacts. After being connected to each other, electronic elements may constitute an electronic circuit with a specific function. A common manner of connecting the electronic elements is welding onto a substrate. The electronic element may be an individual package, such as a resistor, a capacitor, an inductor, a transistor, and a diode, or a group with different complexity, such as an integrated circuit (Integrated Circuit, IC).

An electronic device is a device that includes a plurality of types of electronic elements such as an integrated circuit, a transistor, and an electronic tube and functions by applying electronic technology software, for example, a desktop computer, a notebook computer, a tablet computer, a game console, a mobile phone, an electronic watch, a router, a set-top box, a television, or a modem.

When the electronic device works, heat is generated, causing a rapid increase in an internal temperature of the device. A direct reason is power consumption of the electronic element. All electronic elements have different degrees of power consumption, and heat generation intensity of the electronic element changes with power consumption. If the heat is not dissipated in a timely manner, the electronic element continuously heats up, and finally fails due to overheating, resulting in reduced functional stability of the electronic device and even a complete functional failure. In addition, as electronic devices gradually develop toward miniaturization, lightness and thinness, and high performance, integration of an electronic element in the electronic device is also increasingly high, accompanied by increasingly high power consumption. How to rapidly and effectively dissipate heat generated by the electronic element is a key problem to be resolved in development of the electronic device toward miniaturization, lightness and thinness, and high performance.

Capillary pressure-driven liquid flow and vapor-liquid phase change phenomena are common in nature and an industrial process, and play a very important role in many applications, such as seawater desalination and freshwater purification, microfluidic management, and high-efficiency heat and mass transfer. Especially, for cooling of the above-mentioned electronic element with a high power density, a heat pipe heat sink, a vapor chamber, and a capillary microgroove evaporator that are used are heat dissipation apparatuses that use capillary pressure-driven vapor-liquid phase change phenomena to implement cooling.

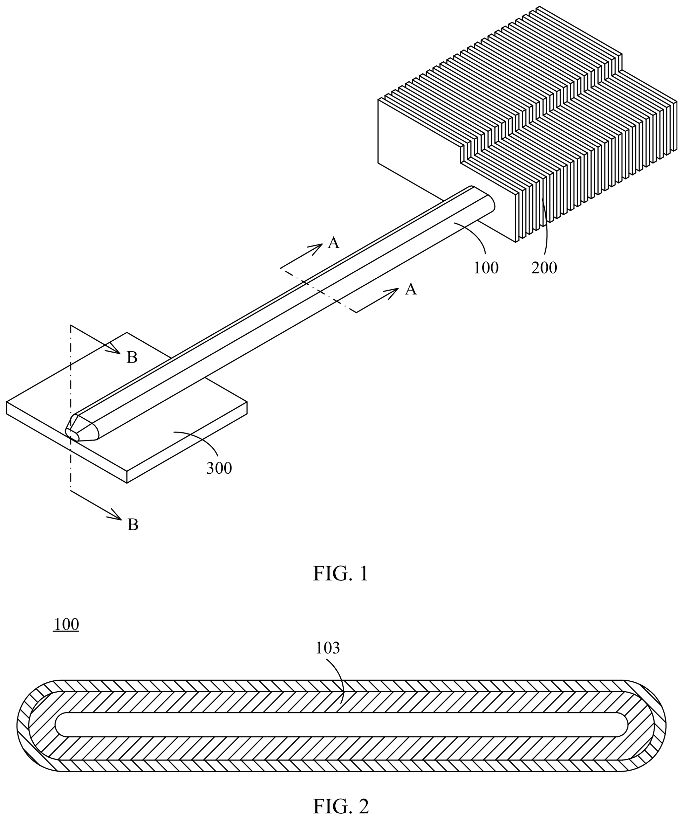

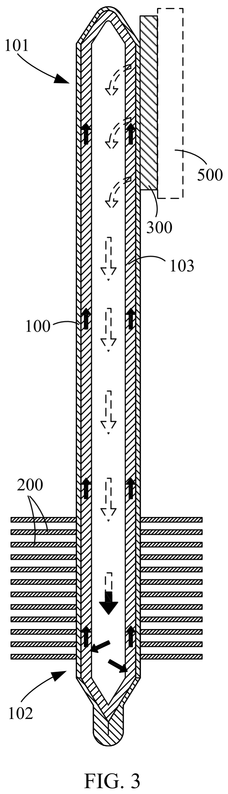

FIG. 1 is a schematic diagram of a heat pipe heat sink in a related technology. FIG. 2 is a sectional view taken along A-A in FIG. 1. FIG. 3 is a sectional view taken along B-B in FIG. 1.

As shown in FIG. 1-FIG. 3, a heat pipe heat sink in a related technology mainly includes a heat pipe 100 (Heat pipe), a thermally conductive plate 300, and a heat dissipation assembly 200 (such as a fin). Generally, one end of the heat pipe 100 is used as an evaporation part 101, and the other end of the heat pipe is used as a condensation part 102. The evaporation part 101 is attached to and in contact with an electronic element 500 by using the thermally conductive plate 300. The condensation part 102 is sleeved by the heat dissipation assembly 200, and the heat pipe 100 has a cavity therein for encapsulating a working fluid (not shown in the figure).

Still as shown in FIG. 3, when the electronic element 500 generates heat during working, heat is conducted to the evaporation part 101 of the heat pipe 100 by using the thermally conductive plate 300. The working fluid therein is vaporized, and then flows to the relatively cool condensation part 102 by using the cavity of the heat pipe 100. In this case, the condensation part 102 dissipates heat by using the external heat dissipation assembly 200, so that the vaporized working fluid is restored to a liquid phase. Then, the liquid-phase working fluid is driven to flow back to the evaporation part 101 by using a capillary pressure generated by a capillary structure 103 on an inner wall of the heat pipe 100. In this way, circulation is performed, so that a heat transfer action can be repeated. Capillary performance of the capillary structure 103 represents heat transfer performance of the heat pipe 100. Better capillary performance indicates a stronger heat transfer capability of the heat pipe 100, and higher heat dissipation efficiency of the heat pipe heat sink.

When capillary performance of the capillary structure 103 is evaluated, a capillary pressure and a permeability are two most important parameters. The capillary pressure reflects a driving force for driving the liquid to flow in the capillary structure 103, and the permeability reflects resistance encountered when the liquid flows in the capillary structure 103. When a porosity (namely, a ratio of voids/pores to a total volume) of a capillary structure 103 is a specific value, a larger pore size indicates a larger permeability and smaller flow resistance, but also indicates a smaller capillary pressure, causing a problem of an insufficient driving force, which is not conducive to liquid backflow. Conversely, a smaller pore size indicates an increased capillary pressure, but indicates a reduced permeability, causing a problem of increased flow resistance, which is eventually not conducive to liquid backflow.

Currently, the capillary structure 103 of the mainstream heat pipe 100 includes two types: a copper powder sintered capillary structure and a copper braided mesh capillary structure.

The copper powder sintered capillary structure mostly has a small pore size and has a relatively large capillary pressure as a whole, so that the structure can provide greater power for vapor-liquid circulation in the heat pipe 100, and has good performance in an anti-gravity working state. However, the copper powder sintered capillary structure has a relatively low permeability, causing large liquid flow resistance of the capillary structure 103. As a power gradually increases, mass of the working fluid that participates in vapor-liquid circulation increases. However, excessively large flow resistance causes difficulty when the liquid at the condensation part 102 flows back, causing a dry-out problem at the evaporation part 101 of the heat pipe 100.

Compared with the copper powder sintered capillary structure, the copper braided mesh capillary structure mostly has a relatively large pore size and has a relatively large permeability as a whole, so that flow resistance of the liquid-phase working fluid in a circulation process can be reduced. However, the copper braided mesh capillary structure has a relatively small capillary pressure that is not enough to provide a driving force required for liquid circulation. As a result, liquid condensed by the condensation part 102 cannot rapidly flow back to the evaporation part 101. This gradually deteriorates heat transfer performance of the heat pipe 100.

It can be learned that, how to balance a relationship between the capillary pressure and the permeability, so that the capillary structure 103 can achieve a large permeability while having a relatively large capillary pressure, to reduce liquid backflow resistance, is the key to improving heat transfer performance of the heat pipe 100.

To resolve the foregoing technical problem, this application provides a heat pipe 100, a heat sink 400, and an electronic device. A first capillary structure 20 having a relatively large capillary pressure wraps a second capillary structure 30 having a relatively large permeability, to fully utilize a large driving force generated by the first capillary structure 20 and a low-resistance backflow channel established by the second capillary structure 30, so that a working fluid in the heat pipe 100 can rapidly and fully participate in cyclic heat transfer working in a liquid-vapor phase change, thereby improving heat transfer performance of the heat pipe 100.

The heat pipe 100 provided in this application is described in detail with reference to the accompanying drawings.

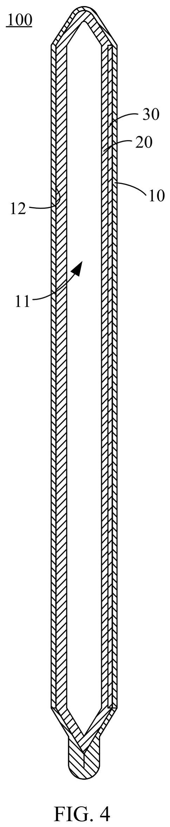

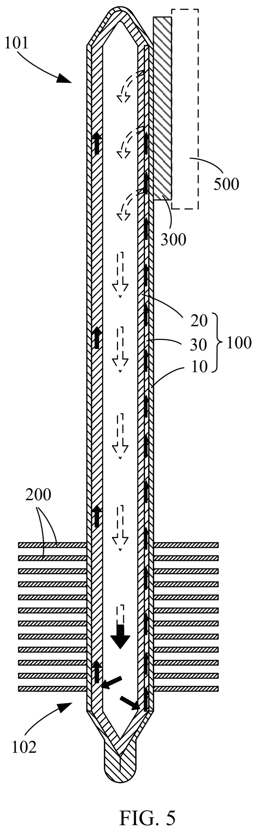

FIG. 4 is a longitudinal sectional view of a heat pipe 100 according to an embodiment of this application. FIG. 5 is a cross-sectional view of a first example of a heat pipe 100 according to an embodiment of this application. A longitudinal section is a surface presented after the heat pipe 100 is cut in an axis direction of the heat pipe 100, and is similar to a cut-away surface of the heat pipe 100 along B-B in FIG. 1. A cross section is a surface exposed after the heat pipe 100 is cut in a direction perpendicular to the axis of the heat pipe 100, and is similar to a cut-away surface of the heat pipe 100 along A-A in FIG. 1.

As shown in FIG. 4-FIG. 5, an embodiment of this application provides a heat pipe 100, including a pipe body 10, a first capillary structure 20, and a second capillary structure 30.

The pipe body 10 has an accommodation cavity 11 therein for sealing a working fluid (not shown). Two ends of the pipe body 10 are respectively an evaporation part 101 and a condensation part 102.

The first capillary structure 20 is distributed in an axial direction (or a length direction) of the pipe body 10, and the first capillary structure 20 is attached to an inner pipe surface 12 of the pipe body 10.

The second capillary structure 30 is also distributed in the axial direction of the pipe body 10, and the second capillary structure 30 is wrapped inside the first capillary structure 20.

The first capillary structure 20 and the second capillary structure 30 are configured such that: a capillary pressure of the first capillary structure 20 is greater than a capillary pressure of the second capillary structure 30, and a permeability of the second capillary structure 30 is greater than a permeability of the first capillary structure 20.

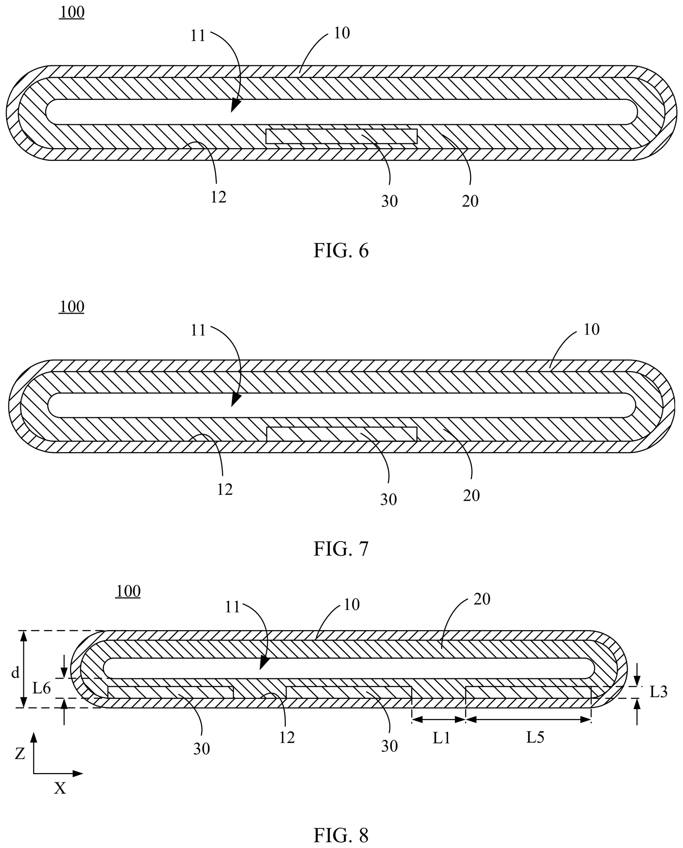

FIG. 6 is a schematic diagram of a working principle of a heat pipe 100 according to an embodiment of this application. A dashed arrow in FIG. 6 indicates a flow direction of a vapor-phase working fluid formed through evaporation at the evaporation part 101 after heat absorption, and a solid arrow indicates a flow direction of a liquid-phase working fluid formed through condensation at the condensation part 102 after heat release.

As shown in FIG. 6, when an electronic element 500 generates heat during working, heat is conducted to the evaporation part 101 of the heat pipe 100 by using a thermally conductive plate 300, and the liquid-phase working fluid is evaporated and vaporized into the vapor-phase working fluid by using the first capillary structure 20 attached to the inner pipe surface 12 of the pipe body 10. In this evaporation and vaporization process, a local high pressure is generated at the evaporation part 101, so that the vapor-phase working fluid flows to the condensation part 102 under pressure. The vapor-phase working fluid is condensed into the liquid-phase working fluid after being cooled at the condensation part 102. In a condensation process, heat is released, and is transferred to the condensation part 102 to dissipate the heat to an environment by using a heat dissipation assembly 200. Then, the liquid-phase working fluid infiltrates into the first capillary structure 20 and the second capillary structure 30 of the condensation part 102. Driven by the capillary pressure of the first capillary structure 20, the liquid-phase working fluid flows back in a backflow channel established by the first capillary structure 20 and the second capillary structure 30, and finally flows back to the evaporation part 101 to continue cyclic heat transfer working in a liquid-vapor phase change.

A material with a relatively large capillary pressure is selected for the first capillary structure 20, and a material with a relatively large permeability is selected for the second capillary structure 30. In addition, because the second capillary structure 30 is wrapped inside the first capillary structure 20 and is not exposed to the accommodation cavity 11, an inner surface of the accommodation cavity 11 is entirely the first capillary structure 20. Because the capillary pressure is a surface parameter, the capillary pressure in the heat pipe 100 is entirely from the first capillary structure 20. Based on this case, driven by the relatively large capillary pressure of the first capillary structure 20, the liquid-phase working fluid flows back by using the two channels, namely, both the first capillary structure 20 and the second capillary structure 30. The second capillary structure 30 with low backflow resistance is used as a "high-speed channel" for the liquid-phase working fluid to flow back. Therefore, the liquid-phase working fluid can be rapidly transported to the evaporation part 101. Compared with a heat pipe 100 that is provided only with a first capillary structure 20, the heat pipe 100 in this embodiment of this application has smaller backflow resistance. Compared with a heat pipe 100 that is provided only with a second capillary structure 30, the heat pipe 100 in this embodiment of this application has a larger driving force. Therefore, a design manner in which the first capillary structure 20 wraps the second capillary structure 30 is used, so that the heat pipe 100 in this embodiment of this application facilitates backflow of the liquid-phase working fluid, and accelerates a liquid-vapor phase circulation speed. Therefore, a heat transfer capability of the heat pipe 100 can be improved, to effectively avoid dry-out at the evaporation part 101 and liquid aggregation at the condensation part 102, so that the heat pipe 100 is not prone reach a heat transfer limit.

In addition, because the liquid-phase working fluid can flow back to the evaporation part 101 along the second capillary structure 30, the liquid-phase working fluid does not conflict with the vapor-phase working fluid in the accommodation cavity 11, thereby isolating the vapor-phase working fluid from the liquid-phase working fluid. Therefore, counterflow interference between the vapor-phase working fluid and the liquid-phase working fluid that flows back is avoided, so that liquid-vapor phase change cycling in the heat pipe 100 is smoother.

In addition, because the liquid-phase working fluid at the condensation part 102 can be rapidly transported back to the evaporation part 101, liquid aggregation at the condensation part 102 can be avoided, thereby effectively avoiding an abnormal noise problem, and improving user experience. A specific reason is as follows: For the heat pipe 100 in a related technology, due to a design defect in the capillary structure 103 of the heat pipe, the liquid-phase working fluid has difficulty in flowing back, and a large amount of liquid is prone to aggregate at the condensation part 102. When the heat pipe 100 or the electronic device is reversed, the large amount of liquid aggregated at the condensation part 102 impacts an inner wall of the heat pipe 100 and produces dripping noise, which affects user experience.

In conclusion, according to the heat pipe 100 in this embodiment of this application, the first capillary structure 20 having a relatively large capillary pressure wraps the second capillary structure 30 having a relatively large permeability, so that a tunnel-type composite capillary structure that has a high-speed backflow channel is formed in the heat pipe 100, to fully utilize advantages of a large driving force generated by the first capillary structure 20 and low backflow resistance of the second capillary structure 30, so that the working fluid in the heat pipe 100 rapidly and fully participates in cyclic heat transfer in a liquid-vapor phase change, thereby improving heat transfer performance of the heat pipe 100.

Optionally, the working fluid may be any liquid conducive to evaporation and heat dissipation, and may be water, an inorganic compound, an organic compound, liquid metal, a refrigerant, or a mixture of any two or more of the foregoing substances, all of which may be the working fluid used in this embodiment of this application.

Specifically, when the working fluid is water, distilled water or deionized water may be used.

Specifically, when the working fluid is an organic compound, at least one of ethanol, methanol, and acetone may be used.

Optionally, a size of the accommodation cavity 11 may be determined based on power consumption of the electronic element 500. When power consumption of the electronic element 500 is relatively high, a large amount of heat is generated. In this case, the accommodation cavity 11 may be relatively large, to accommodate more working fluids and increase a heat conduction rate. When power consumption of the electronic element 500 is relatively low, a small amount of heat is generated by the electronic element 500. In this case, the accommodation cavity 11 is relatively small, which can also achieve a purpose of heat conduction. In this case, a filling amount of the working fluid can also be reduced, so that manufacturing costs of the heat pipe 100 are reduced.

Optionally, the first capillary structure 20 may include at least one of a metal powder sintered body 51, a non-metal powder sintered body 56, and a metal braided mesh 52, but is not limited thereto.

Sintering refers to the following process: At a high temperature (not higher than a melting point), solid particles of a raw green compact are bonded to each other, grains grow, pores and grain boundaries gradually decrease, and a total volume of the raw green compact shrinks and a density thereof increases through material transfer, and finally the raw green compact becomes a dense polycrystalline sintered body with a specific microstructure. This phenomenon is referred to as a sintering process.

The metal powder sintered body 51 may include but is not limited to being formed by sintering copper powder, and the non-metal powder sintered body 56 may include but is not limited to being formed by sintering ceramic powder. The metal powder sintered body 51 and the non-metal powder sintered body 56 mostly have a small pore size and have a relatively large capillary pressure as a whole, which can provide a larger driving force for vapor-liquid circulation in the heat pipe 100.

The metal braided mesh 52 is a mesh structure formed after a plurality of metal wires are interleaved and braided with each other. When the metal braided mesh 52 is used as the first capillary structure 20, a gap between the metal wires in the evaporation part 101 may be used as an evaporation channel for evaporating the liquid-phase working fluid into a vapor phase, and a gap between the metal wires in another part other than the evaporation part 101 may also be used as a backflow channel of the liquid-phase working fluid. When the metal braided mesh 52 is used as the second capillary structure 30, a gap between the metal wires is used as a backflow channel of the liquid-phase working fluid.

A material of the metal wire used for the metal braided mesh 52 includes copper or aluminum. Compared with the metal braid 55, the metal braided mesh 52 mostly has a relatively small gap size and has a relatively large capillary pressure as a whole, which can provide a larger driving force for vapor-liquid circulation in the heat pipe 100. Therefore, when the metal braided mesh 52 forms the first capillary structure 20, the second capillary structure 30 includes the metal braid 55. For details, refer to the following embodiment.

Optionally, the second capillary structure 30 may include at least one of a metal foam 53, a non-metal fiber body 54, a metal braided mesh 52, and a metal braid 55, but is not limited thereto.

The metal foam 53 is a special metal material that includes a foam pore. The pore inside the metal foam forms a backflow high-speed channel of the liquid-phase working fluid. The metal foam 53 that may be used to form the second capillary structure 30 in this application includes foam aluminum, foam nickel, foam copper, and the like. Compared with the metal powder sintered body 51 and the non-metal powder sintered body 56, the metal foam 53 mostly has a relatively large pore size and has a relatively large permeability as a whole, so that flow resistance of the liquid-phase working fluid in a circulation process can be reduced.

Optionally, there are many methods for manufacturing the metal foam 53. Based on different physical states of metal or alloy when the metal or the alloy is processed, manufacturing methods for obtaining a metal foam material may fall into a liquid-phase method, a powder solid-phase method, an ionic method (a metal ion solution), and a vapor-phase method (a metal vapor or a gaseous intermetallic compound). Most commonly used manufacturing methods are a gas injection method, a melt foaming method, a powder metallurgy method, and an infiltration casting method.

Optionally, the non-metal fiber body 54 in this application includes but is not limited to a glass fiber body or a carbon fiber body.

Specifically, glass fiber is an inorganic non-metal material with excellent performance, and is made from six types of ores such as pyrophyllite, quartz sand, limestone, dolomite, boron-calcium stone, and boron-magnesium stone by using a process such as high temperature melting, drawing, winding, and braiding. The glass fiber is generally used as a reinforcing material in a composite material, an electrical insulation material, and a thermal insulation material. In this application, the glass fiber body that may form the second capillary structure 30 is also referred to as glass wool, and is fixed-length glass fiber. The fiber of the glass fiber body is relatively short, and is generally less than 150 mm or shorter. In terms of morphology, the glass fiber body is fluffy, similar to cotton, and has a large quantity of pores inside. The pore is a backflow channel of the liquid-phase working fluid.

Specifically, carbon fiber is high-strength and high-modulus fiber whose carbon content is more than 90%. In this application, the carbon fiber body that may form the second capillary structure 30 is a porous material braided from the carbon fiber, and a pore channel inside the carbon fiber is a backflow channel of the liquid-phase working fluid.

For either the glass fiber body or the carbon fiber body, when compared with the metal powder sintered body 51 and the non-metal powder sintered body 56, the glass fiber body or the carbon fiber body mostly has a relatively large pore size and has a relatively large permeability as a whole, so that flow resistance of the liquid-phase working fluid in a circulation process can be reduced.

The metal braid 55 is formed by spirally twisting and bundling a plurality of metal wires, and is similar to a braided hairstyle commonly seen in women's daily life. Similar to the metal braided mesh 52, a gap between the metal wires in the metal braid 55 is a backflow channel of the liquid-phase working fluid.

A material of the metal wire used for the metal braid 55 includes copper or aluminum. Compared with the metal powder sintered body 51, the non-metal powder sintered body 56, and the metal braided mesh 52, the metal braid 55 mostly has a relatively large gap size and has a relatively large permeability as a whole, so that flow resistance of the liquid-phase working fluid in a circulation process can be reduced.

Optionally, in this application, the capillary structure design of the heat pipe 100 may be further applied to a vapor chamber. The vapor chamber includes an evaporation region in the middle and a condensation region around the evaporation region. The first capillary structure 20 is attached to an inner cavity wall of the vapor chamber. A plurality of second capillary structures 30 are distributed in a divergent manner in a direction from the evaporation region as a start point to the condensation region. The second capillary structure 30 is wrapped inside the first capillary structure 20. The capillary pressure of the first capillary structure 20 is greater than the capillary pressure of the second capillary structure 30, and the permeability of the second capillary structure 30 is greater than the permeability of the first capillary structure 20.

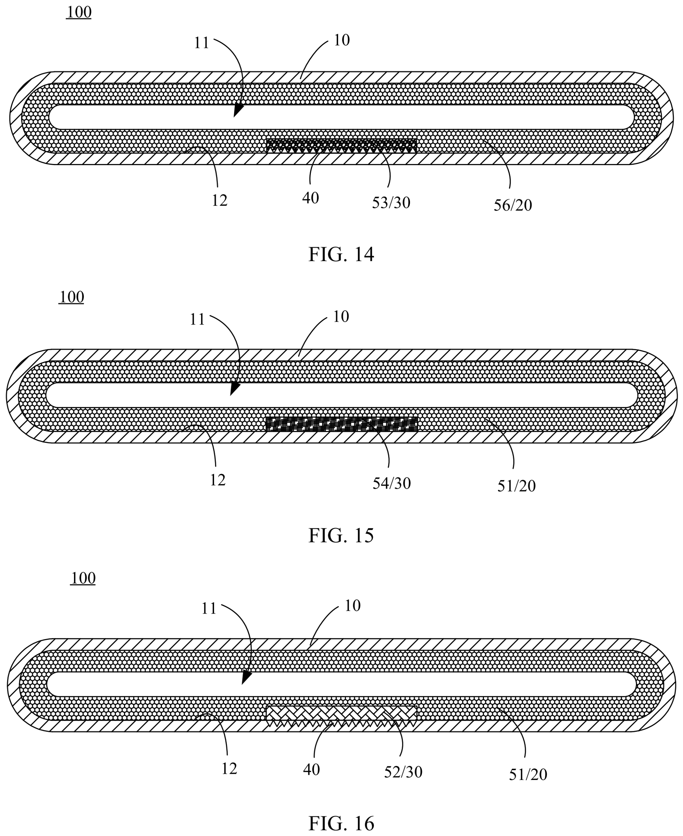

In an embodiment provided in this application, the heat pipe 100 further includes a groove capillary structure 40 disposed on the inner pipe surface 12, for example, a case shown in FIG. 16 below. For details, refer to the following embodiment.

In an embodiment provided in this application, the heat pipe 100 further includes a groove capillary structure 40 disposed on the second capillary structure 30, for example, a case shown in FIG. 14 in the following embodiment.

In an embodiment provided in this application, the heat pipe 100 further includes a groove capillary structure 40 disposed on the inner pipe surface 12 and the second capillary structure 30.

In the foregoing several embodiments, the additionally disposed groove capillary structure 40 can further improve the permeability inside the entire heat pipe 100, thereby further reducing backflow resistance of the liquid-phase working fluid.

Optionally, as shown in FIG. 6, the second capillary structure 30 may be entirely wrapped inside the first capillary structure 20. However, in this case, in a manufacturing stage, the second capillary structure 30 is not easy to be positioned. For example, the first capillary structure 20 includes the metal powder sintered body 51, and the second capillary structure 30 includes the metal foam 53. During manufacturing, a core rod is first placed in the pipe body 10, so that a gap for forming the first capillary structure 20 is formed between the core rod and the inner pipe wall. Then, the metal foam 53 is placed and to-be-sintered metal powder is filled in sequence. Finally, the metal powder is cured by using a heating and sintering process and the metal foam 53 is tightly wrapped therein. It may be found that, because the metal foam 53 has no support surface around the metal foam, the metal foam 53 cannot be accurately positioned in the metal powder. Consequently, displacement is easily generated, resulting in excessively thin metal powder on a surface of the metal foam 53. This affects capillary performance of the entire heat pipe 100.

FIG. 7 is a cross-sectional view of a second example of a heat pipe 100 according to an embodiment of this application.

To resolve the foregoing problem, for ease of implementation and manufacturing, as shown in FIG. 7, in an embodiment provided in this application, a side that is of the second capillary structure 30 and that faces the inner pipe surface 12 is exposed from the first capillary structure 20 and abuts against the inner pipe surface 12.

An example in which the first capillary structure 20 includes the metal powder sintered body 51 and the second capillary structure 30 includes the metal foam 53 is still used. During manufacturing, a simple auxiliary tool (for example, a support arm) may be first inserted into a gap to press the metal foam 53 against the inner pipe surface 12. Then, the metal powder is filled. In this case, the filled metal powder can already provide predetermined positioning for the metal foam 53. Then, the auxiliary tool is removed, and a gap left by the auxiliary tool continues to be filled. After the gap is fully filled, the metal foam 53 can be accurately restrained.

It can be learned that in this embodiment, the side that is of the second capillary structure 30 and that faces the inner pipe surface 12 is exposed from the first capillary structure 20 and abuts against the inner pipe surface 12. In this way, a side of the second capillary structure 30 has a support surface, to facilitate positioning of the second capillary structure 30, and facilitate implementation and manufacturing.

Optionally, in an embodiment provided in this application, the groove capillary structure 40 is disposed on a part that is of the second capillary structure 30 and that abuts against the inner pipe surface 12. This facilitates manufacturing. For how to understand the advantage, refer to the following descriptions.

An example in which the first capillary structure 20 includes the metal powder sintered body 51 and the second capillary structure 30 includes the metal foam 53 is still used. During manufacturing, the groove capillary structure 40 is disposed at a part that is of the metal foam 53 and that abuts against the inner pipe surface 12. In this way, the metal foam 53 can form a barrier for the groove capillary structure 40, so that the metal powder is not prone to be filled in the groove during filling, thereby making manufacturing easier. Otherwise, the groove needs to be protected to prevent the metal powder from being mistakenly filled into the groove.

FIG. 8 is a cross-sectional view of a third example of a heat pipe 100 according to an embodiment of this application.

As shown in FIG. 8, in an embodiment provided in this application, there are a plurality of second capillary structures 30, and the plurality of second capillary structures 30 are disposed at intervals in a circumferential direction of the pipe body 10.

In this embodiment, the plurality of second capillary structures 30 disposed at intervals may further improve a backflow speed of the liquid-phase working fluid, thereby improving a heat transfer capability of the heat pipe 100.

Optionally, the plurality of second capillary structures 30 include a same material.

For example, two second capillary structures 30 include the metal foam 53.

For another example, three second capillary structures 30 all include the metal braided mesh 52.

For another example, four second capillary structures 30 all include the metal braid 55.

Optionally, the plurality of second capillary structures 30 may include different materials.

For example, two second capillary structures 30 respectively include the metal foam 53 and the non-metal fiber body 54.

For another example, three second capillary structures 30 respectively include two metal foams 53 and one metal braided mesh 52.

For another example, four second capillary structures 30 respectively include the metal foam 53, the non-metal fiber body 54, the metal braided mesh 52, and the metal braid 55.

Still as shown in FIG. 8, in an embodiment provided in this application, an interval distance L1 between the plurality of second capillary structures 30 is 2-4 mm.

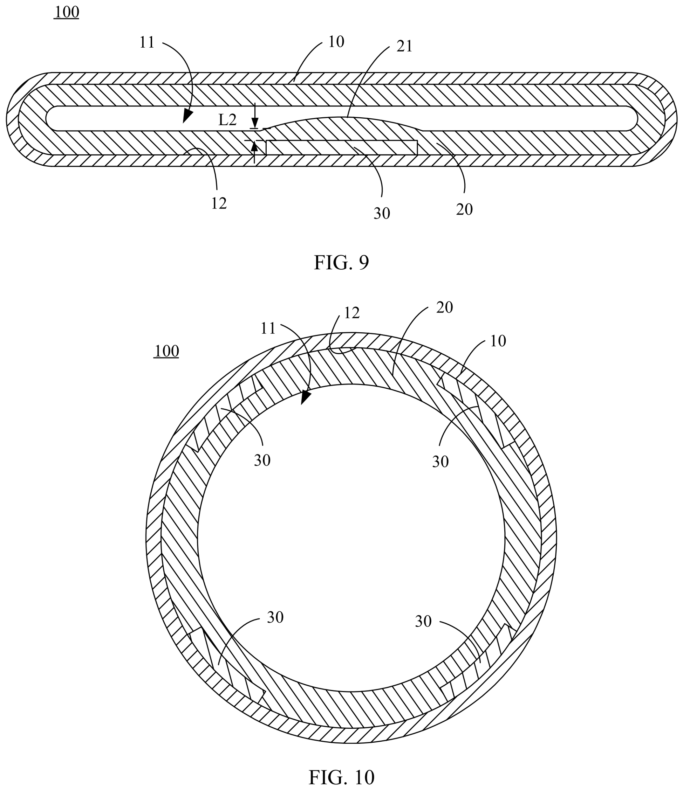

FIG. 9 is a cross-sectional view of a fourth example of a heat pipe 100 according to an embodiment of this application.

As shown in FIG. 9, in an embodiment provided in this application, a part that is of the first capillary structure 20 and that corresponds to the second capillary structure 30 has a protrusion part 21.

In this embodiment, the protrusion part 21 is provided to make the part that is of the first capillary structure 20 and that corresponds to the second capillary structure 30 have a sufficient thickness, so that the first capillary structure 20 can have enough wrapping and fastening strength for the second capillary structure 30, and the second capillary structure 30 is prevented from easily falling off because the part is excessively thin. This improves vibration resistance of the heat pipe 100, and can also ensure structural stability of the first capillary structure 20 and the second capillary structure 30 during severe vibration, thereby improving reliability of the heat pipe 100.

Still as shown in FIG. 9, in an embodiment provided in this application, an edge of the protrusion part 21 is smoothly transitionally transitioned to a surface of the first capillary structure 20.

In this embodiment, the edge of the protrusion part 21 is smoothly transitionally transitioned to the surface of the first capillary structure 20, so that a sharp corner that interferes with flow of airflow is avoided at the protrusion part 21. When the vapor-phase working fluid at the evaporation part 101 flows to the condensation part 102, the protrusion part 21 in this embodiment can reduce a blocking effect on the vapor-phase working fluid, so that the vapor-phase working fluid can also rapidly flow to the condensation part 102. This also accelerates a liquid-vapor phase circulation speed, and can improve a heat transfer capability of the heat pipe 100. Therefore, the heat pipe 100 has good temperature uniformity between cold and hot ends, so that the heat pipe is not prone to reach a heat transfer limit.

Still as shown in FIG. 9, in an embodiment provided in this application, a distance L2 from a surface of the protrusion part 21 to the second capillary structure 30 is greater than 0.3 mm. For example, L2 is 0.35 mm, 0.4 mm, or 0.45 mm, and may be adjusted based on a size of the accommodation cavity 11.

The distance L2 from the surface of the protrusion part 21 to the second capillary structure 30 may be further understood as a thickness of the first capillary structure 20 in a range of an upper surface of the second capillary structure 30, as shown in FIG. 9.

In this embodiment, the distance from the surface of the protrusion part 21 to the second capillary structure 30 is further limited, that is, L2>0.3 mm, so that the protrusion part 21 can adequately cover the second capillary structure 30, to ensure that the second capillary structure 30 is reliably fastened inside the first capillary structure 20.

Still as shown in FIG. 8, in some embodiments provided in this application, a thickness L3 of the second capillary structure 30 is 0.2-0.7 mm. For example, L3 is 0.2 mm, 0.4 mm, 0.5 mm, 0.6 mm, or 0.7 mm, and may be adjusted based on power consumption of the electronic element 500.

The thickness L3 of the second capillary structure 30 may be further understood as a thickness of the second capillary structure 30 in a Z direction, as shown in FIG. 8.

Still as shown in FIG. 8, in some embodiments provided in this application, a width L5 of the second capillary structure 30 is 2-8 mm. For example, L5 is 2 mm, 5 mm, 6 mm, 7 mm, or 8 mm, and may be adjusted based on power consumption of the electronic element 500.

The width L5 of the second capillary structure 30 may be further understood as a width of the second capillary structure 30 in an X direction, as shown in FIG. 8.

Still as shown in FIG. 8, in some embodiments provided in this application, a thickness L6 of the first capillary structure 20 is 0.4-1.1 mm. For example, L6 is 0.4 mm, 0.5 mm, 0.6 mm, 0.7 mm, 0.8 mm, 0.9 mm, or 1.1 mm.

The thickness L6 of the first capillary structure 20 may be further understood as a thickness of the first capillary structure 20 in a Z direction, as shown in FIG. 8.

Optionally, the heat pipe 100 in this application may be cylindrical or flat. Heat pipes 100 of a plurality of styles may be applied to different types of electronic devices, and can be flexibly selected based on internal layout space of the electronic device.

FIG. 10 is a cross-sectional view of a fifth example of a heat pipe 100 according to an embodiment of this application.

As shown in FIG. 10, in an embodiment provided in this application, the heat pipe 100 is cylindrical, that is, a cross-sectional shape of the pipe body 10 is circular, and the first capillary structure 20 is disposed in a circle around the inner pipe surface 12 in the circumferential direction of the pipe body 10. In addition, the plurality of second capillary structures 30 are further disposed at intervals in the circumferential direction of the pipe body 10.

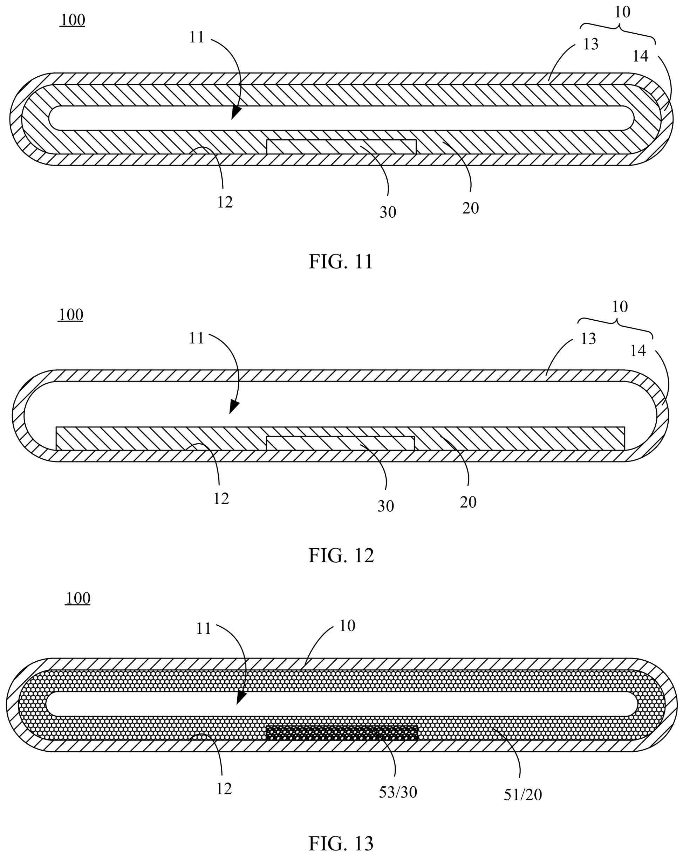

FIG. 11 is a cross-sectional view of a sixth example of a heat pipe 100 according to an embodiment of this application.

As described above, the heat pipe 100 may be flat, that is, in an embodiment provided in this application, as shown in FIG. 11, the pipe body 10 includes two opposite flat pipe walls 13 and two opposite curved pipe walls 14.

In this embodiment, the flat heat pipe 100 may be applied to an electronic device with a thickness limit, so that the heat pipe 100 can meet a design requirement of lightness and thinness.

When the heat pipe 100 is flat, as shown in FIG. 11, the first capillary structure 20 may be disposed in a circle around the inner pipe surface 12 in the circumferential direction of the pipe body 10, that is, the first capillary structure 20 entirely covers the inner pipe surface 12 of the pipe body 10.

Alternatively, FIG. 12 is a cross-sectional view of a seventh example of a heat pipe 100 according to an embodiment of this application. As shown in FIG. 12, in an embodiment of this application, the first capillary structure 20 and the second capillary structure 30 are disposed on either of the two flat pipe walls 13.

When the heat pipe 100 is flat, only the flat pipe wall 13 on a side facing the thermally conductive plate 300 is actually used to be in contact with the electronic element 500 for heat exchange. Therefore, the first capillary structure 20 and the second capillary structure 30 may be disposed only on the flat pipe wall 13, so that material costs used to manufacture the capillary structure can be reduced.

When the heat pipe 100 is flat, and the first capillary structure 20 entirely or partially covers the inner pipe surface 12 of the pipe body 10, there may be a plurality of design types, which are specifically shown in the following Table 1.

Table 1 Summary of design parameters of flat heat pipes

| | Heat pipe type | Quantity of second capillary structures | Width L5 of the second capillary structure (mm) | Thickness L3 of the second capillary structure (mm) | Distance L1 between adjacent second capillary structures (mm) | Thickness L6 of the first capillary structure (mm) |
|---|---|---|---|---|---|---|
| Full coverage of the inner pipe surface | D6 | 1-2 | 2-5 | 0.2-0.3 | 2-3 | 0.4-0.5 |
| | D8 | 1-2 | 2-6 | 0.2-0.4 | 2-4 | 0.4-0.6 |
| | D10 | 1-2 | 2-7 | 0.2-0.4 | 2-4 | 0.4-0.7 |
| | D12 | 1-3 | 2-8 | 0.2-0.5 | 2-4 | 0.4-0.8 |
| Half coverage of the inner pipe surface | D6 | 1-2 | 2-5 | 0.2-0.4 | 2-3 | 0.4-0.8 |
| | D8 | 1-2 | 2-6 | 0.2-0.5 | 2-4 | 0.5-0.9 |
| | D10 | 1-2 | 2-7 | 0.2-0.6 | 2-4 | 0.5-1.0 |
| | D12 | 1-3 | 2-8 | 0.2-0.7 | 2-4 | 0.5-1.1 |

As mentioned above, the heat pipe 100 may be cylindrical or flat. When the flat heat pipe 100 is manufactured, a cylindrical heat pipe 100 with a specified diameter D may be first manufactured, and then the cylindrical heat pipe is pressed into a flat shape with a specified thickness d by using a hydraulic apparatus, to form the flat heat pipe 100. D6, D8, D10, and D12 in Table 1 indicate diameter types of cylindrical heat pipe blanks used to manufacture the flat heat pipe 100. For example, D6 indicates that the flat heat pipe 100 is manufactured by using a cylindrical heat pipe blank with a diameter D of 6 mm.

In addition, the thickness d mentioned herein is an overall thickness of the flat heat pipe 100, and may be understood as an overall thickness d of the heat pipe 100 in the Z direction, as shown in FIG. 8.

FIG. 13 is a cross-sectional view of an eighth example of a heat pipe 100 according to an embodiment of this application.

As shown in FIG. 13, in an embodiment provided in this application, the first capillary structure 20 includes the metal powder sintered body 51, and the second capillary structure 30 includes the metal foam 53.

Compared with the conventional technology, advantages of this embodiment are as follows: The metal foam 53 is accommodated inside the metal powder sintered body 51. Therefore, the heat pipe 100 has a relatively large capillary force and relatively small backflow resistance. In addition, after the metal powder sintered body 51 entirely wraps the metal foam 53, it is ensured that both the metal powder sintered body 51 and the metal foam 53 have sufficient strength, thereby improving vibration resistance and reliability of the capillary structure inside the heat pipe 100.

FIG. 14 is a cross-sectional view of a ninth example of a heat pipe 100 according to an embodiment of this application.

As shown in FIG. 14, in an embodiment provided in this application, the first capillary structure 20 includes the non-metal powder sintered body 56, the second capillary structure 30 includes the metal foam 53, and the groove capillary structure 40 is disposed on the metal foam 53.

In addition to the advantages of the foregoing embodiments, in this embodiment, the additionally disposed groove capillary structure 40 can further improve the permeability inside the entire heat pipe 100, thereby further reducing backflow resistance of the liquid-phase working fluid.

FIG. 15 is a cross-sectional view of a tenth example of a heat pipe 100 according to an embodiment of this application.

As shown in FIG. 15, in an embodiment provided in this application, the first capillary structure 20 includes the metal powder sintered body 51, and the second capillary structure 30 includes the non-metal fiber body 54.

FIG. 16 is a cross-sectional view of an eleventh example of a heat pipe 100 according to an embodiment of this application.

As shown in FIG. 16, in an embodiment provided in this application, the first capillary structure 20 includes the metal powder sintered body 51, the second capillary structure 30 includes the metal braided mesh 52, and the groove capillary structure 40 is disposed on the inner pipe surface 12.

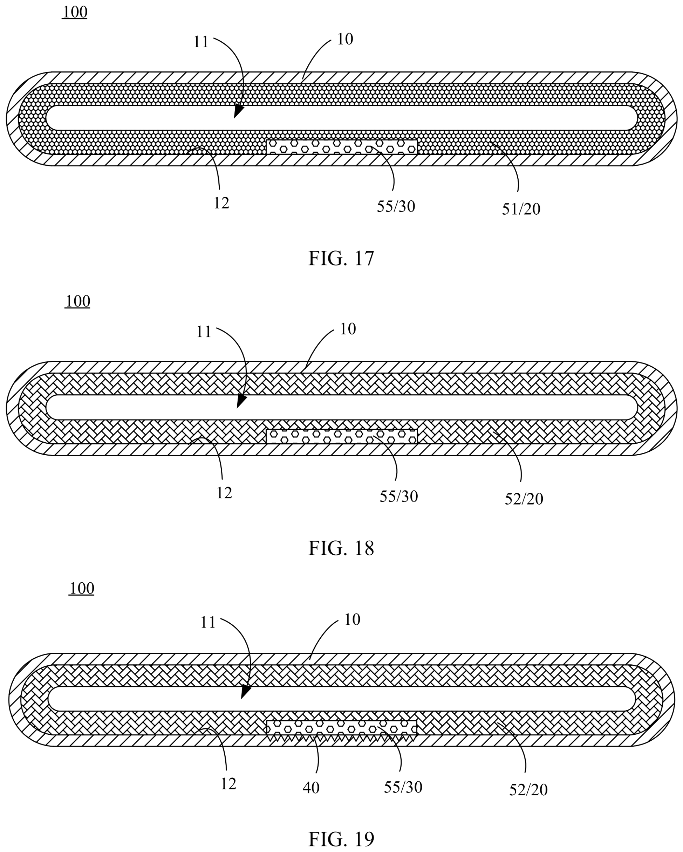

FIG. 17 is a cross-sectional view of a twelfth example of a heat pipe 100 according to an embodiment of this application.

As shown in FIG. 17, in an embodiment provided in this application, the first capillary structure 20 includes the metal powder sintered body 51, and the second capillary structure 30 includes the metal braid 55.

FIG. 18 is a cross-sectional view of a thirteenth example of a heat pipe 100 according to an embodiment of this application.

As shown in FIG. 18, in an embodiment provided in this application, the first capillary structure 20 includes the metal braided mesh 52, and the second capillary structure 30 includes the metal braid 55.

FIG. 19 is a cross-sectional view of a fourteenth example of a heat pipe 100 according to an embodiment of this application.

As shown in FIG. 19, in an embodiment provided in this application, the first capillary structure 20 includes the metal braided mesh 52, the second capillary structure 30 includes the metal braid 55, and the groove capillary structure 40 is disposed on the inner pipe surface 12.

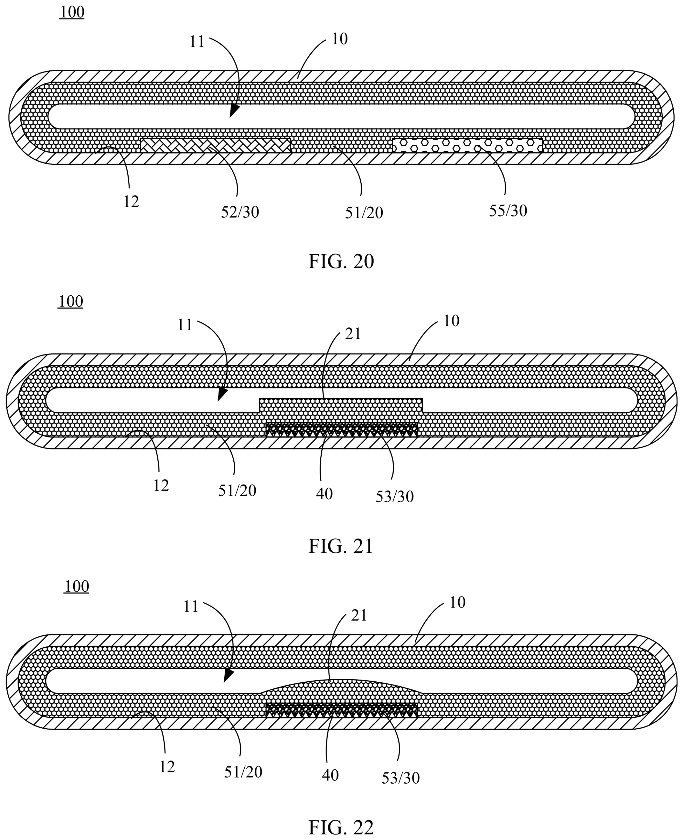

FIG. 20 is a cross-sectional view of a fifteenth example of a heat pipe 100 according to an embodiment of this application.

As shown in FIG. 20, in an embodiment provided in this application, the first capillary structure 20 includes the metal powder sintered body 51, and there are two second capillary structures 30 that respectively include the metal braided mesh 52 and the metal braid 55.

FIG. 21 is a cross-sectional view of a sixteenth example of a heat pipe 100 according to an embodiment of this application.

As shown in FIG. 21, in an embodiment provided in this application, the first capillary structure 20 includes the metal powder sintered body 51, the second capillary structure 30 includes the metal foam 53, the groove capillary structure 40 is disposed on the metal foam 53, and a part that is on the metal powder sintered body 51 and that corresponds to the metal foam 53 has a rectangular protrusion part 21.

Optionally, similar to this embodiment, in the foregoing another embodiment, regardless of a material selected for the first capillary structure 20, a part corresponding to the second capillary structure 30 has a rectangular protrusion part 21. The protrusion part 21 may play a relatively strong fastening role on the second capillary structure 30, to prevent the second capillary structure 30 from falling off.

FIG. 22 is a cross-sectional view of a seventeenth example of a heat pipe 100 according to an embodiment of this application.

As shown in FIG. 22, in an embodiment provided in this application, the first capillary structure 20 includes the metal powder sintered body 51, the second capillary structure 30 includes the metal foam 53, the groove capillary structure 40 is disposed on the metal foam 53, a part corresponding to the metal foam 53 has a protrusion part 21, and an edge of the protrusion part 21 is smoothly transitioned to a surface of the metal foam 53.

Optionally, similar to this embodiment, in the foregoing another embodiment, regardless of a material selected for the first capillary structure 20, a part corresponding to the second capillary structure 30 has a protrusion part 21, and the edge of the protrusion part 21 is smoothly transitioned to the surface of the first capillary structure 20, so that a sharp corner that interferes with flow of airflow is avoided at the protrusion part 21. When the vapor-phase working fluid at the evaporation part 101 flows to the condensation part 102, the protrusion part 21 can reduce a blocking effect on the vapor-phase working fluid, so that the vapor-phase working fluid can also rapidly flow to the condensation part 102. This also accelerates a liquid-vapor phase circulation speed.

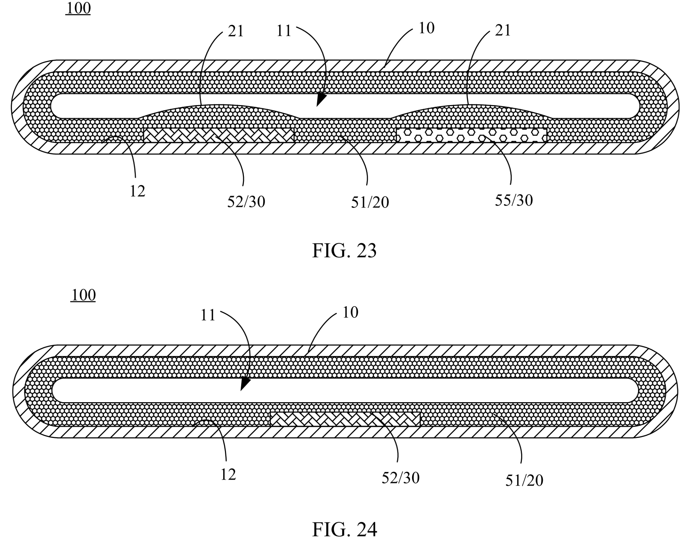

FIG. 23 is a cross-sectional view of an eighteenth example of a heat pipe 100 according to an embodiment of this application.

As shown in FIG. 23, in an embodiment provided in this application, the first capillary structure 20 includes the metal powder sintered body 51, there are two second capillary structures 30 that respectively include the metal braided mesh 52 and the metal braid 55, and parts that are on the metal powder sintered body 51 and that correspond to the metal braided mesh 52 and the metal braid 55 each have a protrusion part 21.

Optionally, similar to this embodiment, in another embodiment, when there are a plurality of second capillary structures 30, a part that is on the first capillary structure 20 and that corresponds to each second capillary structure 30 has a protrusion part 21. The protrusion part 21 may be in a rectangular shape, or may have a smooth edge.

FIG. 24 is a cross-sectional view of a nineteenth example of a heat pipe 100 according to an embodiment of this application.

As shown in FIG. 24, in an embodiment provided in this application, the first capillary structure 20 includes the metal powder sintered body 51, and the second capillary structure 30 includes the metal braided mesh 52.

In this embodiment, the metal powder specifically used is copper powder with a particle diameter between 50-200 $\mu$m. The metal braided mesh 52 is obtained through braiding by using a copper wire with a wire diameter of 0.03-0.06 mm (for example, 0.03 mm, 0.04 mm, 0.05 mm, or 0.06 mm). A quantity of wires braided into a single strand may be selected from 6-15 (for example, 6, 8, 13, or 15) to form one strand. A quantity of strands braided into a copper wire may be selected from 12-24 (for example, 12, 16, 20, or 24) to form a final copper wire. A quantity of braiding layers of the final copper wire may be selected from 1-4, and a thickness of a copper powder sintered body at an upper layer of the copper wire braided mesh is controlled to be greater than 0.3 mm, to ensure that the copper powder layer can fully cover the copper wire.

$$k_x = \frac{A_1 k_1 + A_2 k_2}{A_1 + A_2}$$

In the foregoing formula, $k_x$ represents a total permeability inside the heat pipe 100, $k_1$ represents a permeability of the first capillary structure 20, $k_2$ represents a permeability of the second capillary structure 30, $A_1$ represents a cross-sectional area of the first capillary structure 20, and $A_2$ represents a cross-sectional area of the second capillary structure 30.

In this embodiment, the copper powder sintered body with a large capillary pressure is used for the first capillary structure 20, and the copper wire braided mesh with a high permeability is used for the second capillary structure 30. Compared with a heat pipe 100 for which only a single copper powder sintered body is used as a capillary structure, in this embodiment, flow resistance of the liquid-phase working fluid in the heat pipe 100 can be reduced. Through simulation calculation, liquid-phase flow resistance can be reduced by about 20-40%.

In addition, in the following, a comparative test is performed on a heat sink 400 that includes the heat pipe 100 in this embodiment. For ease of understanding, technical terms used in the following descriptions are first explained and described below.

A heat dissipation power of the heat sink is heat that can be dissipated by the heat sink 400 per unit time. Generally, the heat dissipation power is measured in watts (W), and is an important indicator for measuring a heat dissipation capability of the heat sink 400. The heat dissipation power of the heat sink 400 is affected by a plurality of factors. Common factors include the following aspects: The first factor is an area of the heat sink 400, and a larger area of the heat sink 400 indicates a larger amount of heat that can be carried by the heat sink 400, and a stronger heat dissipation capability. The second factor is a material thermal conductivity. A higher material thermal conductivity of the heat sink 400 indicates higher heat transfer efficiency and a stronger heat dissipation capability. The third factor is a rotation speed of a fan. The fan in the heat sink 400 can accelerate airflow, and increase heat transfer, thereby improving a heat dissipation capability.

In the following comparative test, the heat pipe 100 in this embodiment and the heat sink 400 that uses the heat pipe 100 are used. Compared with a control group, a model of the heat pipe 100, a pipe wall material, a quantity of heat pipes 100, the heat dissipation assembly 200, a fan parameter, and the like are the same. A difference lies only in the capillary structure in the heat pipe 100. Details are as follows:

A cylindrical heat pipe blank with D12 is pressed into a flat heat pipe 100 with an overall thickness of 2.5 mm. The capillary structure is designed as follows: The copper powder sintered body is used for the first capillary structure 20, and the copper wire braided mesh is used for the second capillary structure 30. Prototype verification is performed on the heat pipe 100. A comparative solution is a heat pipe designed by a conventional heat pipe manufacturer by using an all-copper powder sintered body capillary solution (hereinafter referred to as an all-copper powder solution). Test data is shown in Table 2.

**Table 2 Verification of test data**

| Test item | Solution | Heat dissipation power (W) | Temperature difference between cold and hot ends of a GPU-side heat pipe (°C) | Temperature difference between cold and hot ends of a CPU-side heat pipe (°C) |
|---|---|---|---|---|
| Single heat source test | Solution of this embodiment of this application | 80 | 0.73 | 1.30 |
| | | 100 | 0.96 | 1.45 |
| | | 120 | 0.95 | 2.92 |
| | All-copper powder solution | 80 | 0.71 | 1.35 |
| | | 100 | 0.57 | 3.42 |
| | | 120 | 0.58 | 5.14 |
| Dual heat source test | Solution of this embodiment of this application | 40(GPU)+90(CPU) | 1.47 | 1.03 |
| | | 40(GPU)+110(CPU) | 2.44 | 1.91 |
| | | 40(GPU)+120(CPU) | 1.52 | 2.19 |

(continued)

| Test item | Solution | Heat dissipation power (W) | Temperature difference between cold and hot ends of a GPU-side heat pipe (°C) | Temperature difference between cold and hot ends of a CPU-side heat pipe (°C) |
|---|---|---|---|---|
| | All-copper powder solution | 40(GPU)+90(CPU) | 2.3 | 0.53 |
| | | 40(GPU)+110(CPU) | 2.13 | 3.58 |
| | | 40(GPU)+120(CPU) | 2.98 | 5.67 |

A heat source used in the test is a CPU and a GPU, and a same heat pipe 100 is connected to the CPU and the GPU through heat conduction. The single heat source test means that a heat dissipation test is performed on the heat pipe 100 when only the CPU or the GPU is enabled separately. The dual heat source test means that a heat dissipation test is performed on the heat pipe 100 when both the CPU and GPU are enabled.

It can be learned from the test data in Table 2 that, under the single heat source test condition and the dual heat source test condition, when the temperature difference between the cold and hot ends of the heat pipe 100 is less than 5°C, the composite capillary solution in this embodiment of this application has a heat dissipation power gain compared with the all-copper powder solution. Details are as follows:

For the heat pipe 100 that uses the capillary solution in this embodiment of this application, when the heat dissipation power in the single heat source test is 120W, the temperature difference between the cold and hot ends of the GPU-side heat pipe 100 is only 0.95°C, and the temperature difference between the cold and hot ends of the CPU-side heat pipe 100 is only 2.92°C. It may be reasonably inferred that when the temperature difference between the cold and hot ends of the heat pipe 100 is 5°C, the heat dissipation power of the heat pipe 100 in the capillary solution in this embodiment of this application is necessarily greater than 120W. In contrast, for the heat pipe in the all-copper powder solution, when the heat dissipation power in the single heat source test is 120W, the temperature difference between the cold and hot ends of the CPU-side heat pipe is 5.14°C, which exceeds the requirement that the temperature difference between the cold and hot ends is less than 5°C. Therefore, the heat dissipation power in the all-copper powder solution is clearly smaller, and is expected to be about 100~110W.

For the heat pipe 100 that uses the capillary solution in this embodiment of this application, when the heat dissipation power in the dual heat source test is 40W(GPU)+120W(CPU), the temperature difference between the cold and hot ends of the GPU-side heat pipe is only 1.52°C, and the temperature difference between the cold and hot ends of the CPU-side heat pipe 100 is only 2.19°C. It may be reasonably inferred that when the temperature difference between the cold and hot ends of the heat pipe 100 is 5°C, the heat dissipation power of the heat pipe 100 in the capillary solution in this embodiment of this application is necessarily greater than 40W(GPU)+120W(CPU). In contrast, for the heat pipe in the all-copper powder solution, when the heat dissipation power in the dual heat source test is 40W(GPU)+120W(CPU), the temperature difference between the cold and hot ends of the CPU-side heat pipe is 5.67°C, which exceeds the requirement that the temperature difference between the cold and hot ends is less than 5°C. Therefore, the heat dissipation power in the all-copper powder solution is clearly smaller, and is expected to be 40W(GPU)+100~110W(CPU).

The heat pipe 100 in the composite capillary solution in this embodiment of this application and the heat pipe in the all-copper powder solution are separately mounted into an entire laptop computer to perform an overall function test in case of a single heat source and dual heat sources. Test data is shown in Table 3 and Table 4.

**Table 3 Overall function test data of the heat pipe 100 in the solution of this embodiment of this application**

| | Single heat source test | Dual heat source test |
|---|---|---|
| CPU power (W)/junction temperature (°C) | 70.123/97.798 | 59.253/100 |
| GPU power (W)/junction temperature (°C) | / | 49.86/83.13 |
| Temperature at the hot end of the CPU-side heat pipe (°C) | 64.5 | 72.4 |
| Temperature at the cold end of the CPU-side heat pipe (°C) | 63.1 | 69.6 |
| Temperature at the hot end of the GPU-side heat pipe (°C) | 65.4 | 72.4 |
| Temperature at the cold end of the GPU-side heat pipe (°C) | 62.7 | 68.2 |
| Temperature difference between the cold and hot ends of the CPU-side heat pipe (°C) | 1.4 | 2.8 |

(continued)

|  | Single heat source test | Dual heat source test |
|---|---|---|
| Temperature difference between the cold and hot ends of the GPU-side heat pipe (°C) | 2.7 | 4.2 |

**Table 4 Overall function test data of the heat pipe in the copper powder capillary solution**

|  | Single heat source test | Dual heat source test |
|---|---|---|
| CPU power (W)/junction temperature (°C) | 69.905/100 | 52.341/99.999 |
| GPU power (W)/junction temperature (°C) | / | 49.84/82.63 |
| Temperature at the hot end of the CPU-side heat pipe (°C) | 60.9 | 70.6 |
| Temperature at the cold end of the CPU-side heat pipe (°C) | 57.8 | 66 |
| Temperature at the hot end of the GPU-side heat pipe (°C) | 61.3 | 70.3 |
| Temperature at the cold end of the GPU-side heat pipe (°C) | 57.3 | 64.7 |
| Temperature difference between the cold and hot ends of the CPU-side heat pipe (°C) | 3.1 | 4.6 |
| Temperature difference between the cold and hot ends of the GPU-side heat pipe (°C) | 4 | 5.6 |

During the overall function test, only the CPU is separately tested in the single heat source test. The junction temperature in the table is an actual working temperature of the electronic element.

It may be learned by comparing Table 3 with Table 4 that, during the single heat source test, the CPU junction temperature of the heat pipe 100 that uses the capillary solution in this embodiment of this application is 97.798°C, whereas the CPU junction temperature of the heat pipe that uses the all-copper powder solution is 100°C. It can be learned that, with the heat pipe 100 in this embodiment of this application, the CPU working temperature can be reduced by about 2-3°C.

In terms of power, the CPU power of the heat pipe 100 that uses the capillary solution in this embodiment of this application is 70.123W, whereas the CPU power of the heat pipe that uses the all-copper powder solution is 69.905W. It can be learned that, with the heat pipe 100 in this embodiment of this application, the CPU power can be increased by about 0.2W, and partial working performance of the CPU can be improved.

In terms of temperature difference between the cold and hot ends of the heat pipe, the temperature difference between the cold and hot ends of the CPU-side heat pipe 100 is 1.4°C for the heat pipe 100 that uses the capillary solution in this embodiment of this application, whereas the temperature difference between the cold and hot ends of the CPU-side heat pipe is 3.1°C for the heat pipe that uses the all-copper powder solution. It can be learned that, with the heat pipe 100 in this embodiment of this application, the temperature difference between the cold and hot ends still has a margin of about 3-4°C, and therefore a larger heat dissipation requirement can be loaded.

During the dual heat source test, the CPU power of the heat pipe 100 that uses the capillary solution in this embodiment of this application is 59.253W, the GPU power thereof is 49.86W, and a total power obtained by adding the two powers is 109.113W. The CPU power of the heat pipe that uses the all-copper powder solution is 52.341W, and the GPU power thereof is 102.181W. It can be learned that, with the heat pipe 100 in this embodiment of this application, the CPU+GPU power can be increased by about 7W, and CPU+GPU working performance can be improved.

It can be learned that, compared with a conventional heat pipe in the all-copper powder capillary solution, the heat pipe 100 that uses the composite capillary solution in this embodiment of this application has an advantage of a small temperature difference between the cold and hot ends, is less prone to encounter a case in which dry-out occurs in the evaporation part 101 and liquid aggregation occurs in the condensation part 102, has a larger heat dissipation power, and can load a higher heat dissipation requirement. For the electronic device that uses the heat pipe 100 in this embodiment of this application, a working temperature of the electronic element 500 can be significantly reduced, so that the electronic element 500 has a larger power, and working performance of the electronic device can be improved.

Still as shown in FIG. 5, an embodiment of this application further provides a heat sink 400. The heat sink 400 includes a heat dissipation assembly 200, a thermally conductive plate 300, and the heat pipe 100 provided in any one of the foregoing embodiments. The heat dissipation assembly 200 is sleeved on the condensation part 102 of the heat pipe 100, and the thermally conductive plate 300 is fastened to the evaporation part 101 of the heat pipe 100.

The heat sink 400 in this embodiment of this application includes the heat pipe 100 provided in any one of the foregoing embodiments. Inside the heat pipe 100, a material with a relatively large capillary pressure is selected for the first capillary structure 20, and a material with a relatively large permeability is selected for the second capillary structure 30. In addition, because the second capillary structure 30 is wrapped inside the first capillary structure 20 and is not exposed to the accommodation cavity 11, an inner surface of the accommodation cavity 11 is entirely the first capillary structure 20. Because the capillary pressure is a surface parameter, the capillary pressure in the heat pipe 100 is entirely from the first capillary structure 20. Based on this case, driven by the relatively large capillary pressure of the first capillary structure 20, the liquid-phase working fluid flows back by using the two channels, namely, both the first capillary structure 20 and the second capillary structure 30. The second capillary structure 30 with low backflow resistance is used as a "high-speed channel" for the liquid-phase working fluid to flow back. Therefore, the liquid-phase working fluid can be rapidly transported to the evaporation part 101. Compared with a heat pipe 100 that is provided only with a first capillary structure 20, the heat pipe 100 in this embodiment of this application has smaller backflow resistance. Compared with a heat pipe 100 that is provided only with a second capillary structure 30, the heat pipe 100 in this embodiment of this application has a larger driving force. Therefore, a design manner in which the first capillary structure 20 wraps the second capillary structure 30 is used, so that the heat pipe 100 in this embodiment of this application facilitates backflow of the liquid-phase working fluid, and accelerates a liquid-vapor phase circulation speed. Therefore, a heat transfer capability of the heat pipe 100 can be improved, to effectively avoid dry-out at the evaporation part 101 and liquid aggregation at the condensation part 102, so that the heat pipe 100 is not prone to reach a heat transfer limit. This can effectively improve a heat dissipation power of the heat sink 400.

Optionally, the heat pipe 100 and the thermally conductive plate 300, the heat pipe 100 and the heat dissipation assembly 200 may be bonded, welded, bolted, and fastened to each other, to implement a fixed connection between the heat pipe 100 and both the thermally conductive plate 300 and the heat dissipation assembly 200.

Optionally, the heat dissipation assembly 200 includes but is not limited to a heat dissipation fin and a heat dissipation grille, and can provide a larger heat exchange area. Alternatively, the heat dissipation assembly 200 may be a metal bracket of a functional element in the electronic device. For example, when the electronic device is a mobile phone, the heat dissipation assembly 200 may be a middle frame or a rear cover, to rapidly conduct heat from the inside of the mobile phone to the outside and dissipate the heat to an environment.

Optionally, to improve a heat dissipation effect of the heat dissipation assembly 200, a heat dissipation fin structure, a heat dissipation bump structure, a heat dissipation wave structure, or the like may be disposed on an outer surface of the heat dissipation assembly 200, to increase a heat exchange area on the outer surface of the heat dissipation assembly 200, and rapidly dissipate heat from the electronic element 500 to the environment. Alternatively, a fan is additionally disposed on the outside of the heat dissipation assembly 200, and an airflow direction of the fan directly faces the heat dissipation assembly 200, so that heat from the electronic element 500 is rapidly taken away from the heat dissipation assembly 200 through air cooling.

Optionally, a water cooling mechanism may be further added inside the heat dissipation assembly 200, to further improve a heat dissipation effect. For example, a circulating pump is added. The heat dissipation assembly 200 is a hollow structure, and is provided with a water inlet and a water outlet. The circulating pump separately communicates with the water inlet and the water outlet by using a pipeline, to inject circulating cooling water into the heat dissipation assembly 200.

Specifically, the cooling water is closed and circulated in the pipeline, and heat of the heat dissipation assembly 200 is taken away by the cooling water, and then is dissipated to the environment by using the pipeline. Alternatively, the pipeline is connected to an external heat exchanger, heat of the heat dissipation assembly 200 is taken away by the cooling water and flows into the heat exchanger, and the heat exchanger dissipates the heat through the air.

On a contact surface between the electronic element 500 and the thermally conductive plate 300, although it seems that the contact is good on the outer surface, actually, an area of direct contact is small, and the remaining part is a gap. Thermal resistance of gas in the gap (the thermal resistance is resistance encountered by heat on a heat flow path, and reflects a heat transfer capability of a medium or between media) is relatively large, causing an extremely weak heat conduction capability. This greatly impedes conduction of heat from the electronic element 500 to the heat sink 400. Therefore, the gap needs to be filled with a thermally conductive medium, so that heat conduction is smoother and faster.

Optionally, thermally conductive liquid gold or thermally conductive silicone grease may be applied between the thermally conductive plate 300 and the electronic element 500, so that the gap is filled with the thermally conductive medium, and contact between the heat sink 400 and the electronic element 500 is more tightly fitted by using the thermally conductive medium, to achieve a better heat transfer effect. Therefore, the heat sink 400 can more efficiently dissipate heat generated by the electronic element 500.

Optionally, to avoid a case in which thermal resistance exists inside the heat sink 400 because a gap also exists between the heat pipe 100 and the thermally conductive plate 300 and between the heat pipe 100 and the heat dissipation assembly 200, the thermally conductive medium may also be filled between the heat pipe 100 and the thermally conductive plate 300 and between the heat pipe 100 and the heat dissipation assembly 200.

For the heat sink 400 in this embodiment of this application, a specific type of the electronic element 500 whose heat can be dissipated is not limited. For example, the electronic element 500 may be a central processing unit (central processing unit, CPU), a graphics processing unit (graphics processing unit, GPU), a universal flash storage (universal flash storage, UFS), a system in package (System in Package, SiP) element, an antenna in package (antenna in package, AiP) element, a system on a chip (system on a chip, SOC) element, a double data rate (double data rate, DDR) memory, a radio frequency chip (radio frequency integrated circuit, RF IC), a radio frequency power amplifier (radio frequency power amplifier, RF PA), a power management chip (power management unit, PMU), an embedded multimedia card (embedded multimedia card, EMMC), or the like.

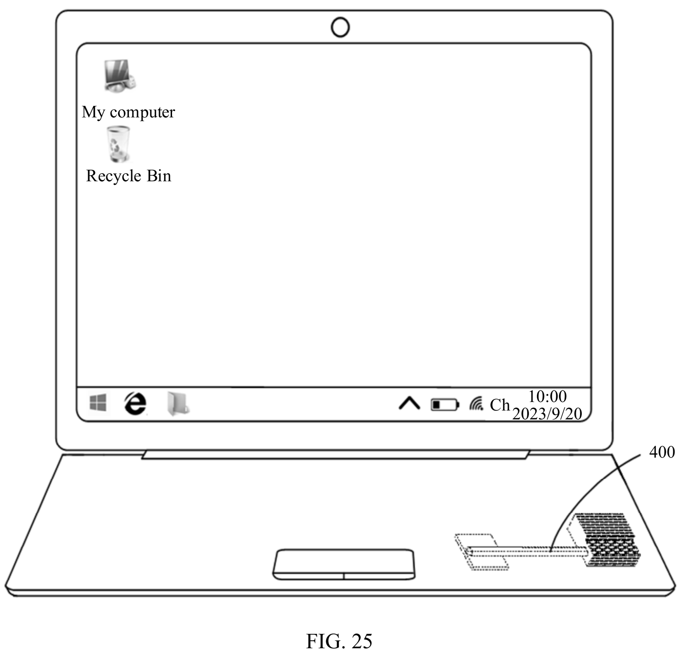

FIG. 25 is a schematic diagram of an electronic device according to an embodiment of this application.

As shown in FIG. 25, an embodiment of this application further provides an electronic device. The electronic device is a notebook computer, and a heat sink 400 is disposed inside a body.

In addition, the electronic device may alternatively be any one of a desktop computer, a tablet computer, a game console, a mobile phone, an electronic watch, a router, a set-top box, a television, and a modem.

Optionally, in the electronic device in this application, in addition to applying the foregoing heat sink 400, a position relationship of the heat sink 400 in the electronic device may be properly laid out, to further improve a heat dissipation effect of the electronic device and improve heat conduction efficiency of the heat sink 400. A specific layout design is as follows: First, an electronic element 500 that is sensitive to a temperature is preferably disposed in a region with a lowest temperature, for example, the bottom of the electronic device, to avoid being mounted directly above a heating component, and a plurality of components are preferably staggered on a horizontal plane. Second, hotspots on a substrate (for example, a printed circuit board, printed circuit board, PCB) are prevented from being concentrated, and an electronic element 500 with a large power is distributed on the substrate as evenly as possible, to ensure uniformity and consistency of surface temperature performance of the substrate. Third, an electronic element 500 that has highest power consumption and that generates a largest amount of heat is disposed near an optimal heat dissipation position in the electronic device, for example, near an air outlet position of the fan. Fourth, electronic elements 500 on a same substrate should be arranged in zones as far as possible based on an amount of generated heat and a heat dissipation degree. An electronic element 500 with a small amount of generated heat or poor thermal resistance is placed at a most upstream position of cooling airflow, and a component with a large amount of generated heat or good thermal resistance is placed at a most downstream position of cooling airflow, for example, a large-scale integrated circuit. Fifth, in a horizontal direction, a large-power electronic element 500 is arranged as close to an edge of the substrate as possible, to shorten a heat transfer path. In a vertical direction, a large-power electronic element 500 is arranged as close to the top of the substrate as possible, to reduce impact on a temperature of another component when these components work.

Finally, it should be noted that the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A heat pipe, comprising:

   a pipe body (10), having an accommodation cavity (11) therein for sealing a working fluid;
   a first capillary structure (20), attached to an inner pipe surface (12) of the pipe body (10); and
   a second capillary structure (30), wrapped inside the first capillary structure (20), wherein
   the first capillary structure (20) and the second capillary structure (30) are configured such that: a capillary pressure of the first capillary structure (20) is greater than a capillary pressure of the second capillary structure (30), and a permeability of the second capillary structure (30) is greater than a permeability of the first capillary structure (20).

2. The heat pipe according to claim 1, wherein the first capillary structure (20) comprises at least one of a metal powder sintered body (51), a non-metal powder sintered body (56), or a metal braided mesh (52).

3. The heat pipe according to claim 1 or 2, wherein the second capillary structure (30) comprises at least one of a metal foam (53), a non-metal fiber body (54), a metal braided mesh (52), or a metal braid (55).

4. The heat pipe according to any one of claims 1-3, further comprising:
   a groove capillary structure (40), disposed on the inner pipe surface (12) and/or the second capillary structure (30).

5. The heat pipe according to any one of claims 1-4, wherein a side that is of the second capillary structure (30) and that faces the inner pipe surface (12) is exposed from the first capillary structure (20) and abuts against the inner pipe surface (12).

6. The heat pipe according to any one of claims 1-5, wherein there are a plurality of second capillary structures (30), and the plurality of second capillary structures (30) are disposed at intervals in a circumferential direction of the pipe body (10).

7. The heat pipe according to any one of claims 1-6, wherein a part that is of the first capillary structure (20) and that corresponds to the second capillary structure (30) has a protrusion part (21).

8. The heat pipe according to claim 7, wherein an edge of the protrusion part (21) is smoothly transitioned to a surface of the first capillary structure (20).

9. The heat pipe according to any one of claims 1-8, wherein the pipe body (10) comprises two opposite flat pipe walls (13) and two opposite curved pipe walls (14).

10. The heat pipe according to claim 9, wherein the first capillary structure (20) and the second capillary structure (30) are disposed on either of the two flat pipe walls (13).

11. The heat pipe according to any one of claims 1-9, wherein the first capillary structure (20) is disposed in a circle around the inner pipe surface (12) in the circumferential direction of the pipe body (10).

12. The heat pipe according to claim 6, wherein an interval distance between two adjacent second capillary structures (30) is 2-4 mm.

13. The heat pipe according to claim 7 or 8, wherein a distance from a surface of the protrusion part (21) to the second capillary structure (30) is greater than 0.3 mm.

14. The heat pipe according to any one of claims 1-13, wherein a thickness of the second capillary structure (30) is 0.2-0.7 mm.

15. The heat pipe according to any one of claims 1-14, wherein a width of the second capillary structure (30) is 2-8 mm.

16. The heat pipe according to any one of claims 1-15, wherein a thickness of the first capillary structure (20) is 0.4-1.1 mm.

17. The heat pipe according to claim 3, wherein a material of the non-metal fiber body (54) comprises glass fiber or carbon fiber.

18. The heat pipe according to claim 3, wherein a material of the metal foam (53) comprises copper or aluminum, a material of the metal braided mesh (52) comprises copper or aluminum, and a material of the metal braid (55) comprises copper or aluminum.

19. A heat sink, comprising a heat dissipation assembly (200), a thermally conductive plate (300), and the heat pipe (100) according to any one of claims 1-18, wherein the heat dissipation assembly (200) is sleeved on a condensation part (102) of the heat pipe (100), and the thermally conductive plate (300) is fastened to an evaporation part (101) of the heat pipe (100).

20. An electronic device, comprising the heat sink (400) according to claim 19.

FIG. 1

FIG. 2

FIG. 3

FIG. 4

FIG. 5

100

11    10

12    30    20

FIG. 6

100

11    10

12    30    20

FIG. 7

100

11    10    20

d

L6

L3

30    12    30

L1    L5

Z

X

FIG. 8

100

FIG. 9

100

FIG. 10

FIG. 11

FIG. 12

FIG. 13

100

11    10

12    40    53/30    56/20

FIG. 14

100

11    10

12    54/30    51/20

FIG. 15

100

11    10

12    40    52/30    51/20

FIG. 16

FIG. 17

FIG. 18

FIG. 19

100

11    10

12    52/30    51/20    55/30

FIG. 20

100

11    21    10

12    51/20    40    53/30

FIG. 21

100

11    21    10

12    51/20    40    53/30

FIG. 22

FIG. 23

FIG. 24

My computer

Recycle Bin

10:00
2023/9/20

400

FIG. 25

## INTERNATIONAL SEARCH REPORT

| International application No. |
|---|
| **PCT/CN2024/110412** |

| A. | CLASSIFICATION OF SUBJECT MATTER |
|---|---|

F28D 15/04(2006.01)i;  F28D 15/02(2006.01)i

According to International Patent Classification (IPC) or to both national classification and IPC

| B. | FIELDS SEARCHED |
|---|---|

Minimum documentation searched (classification system followed by classification symbols)

IPC:  F28D 15

Documentation searched other than minimum documentation to the extent that such documents are included in the fields searched

VEN; CNABS; CNKI: 毛细,阻力, 渗透, 包裹, 埋, capillarity, resistance,permea+, insert+, sunk

Electronic data base consulted during the international search (name of data base and, where practicable, search terms used)

| C. | DOCUMENTS CONSIDERED TO BE RELEVANT | |
|---|---|---|

| Category* | Citation of document, with indication, where appropriate, of the relevant passages | Relevant to claim No. |
|---|---|---|
| X | US 2015204617 A1 (FUJIKURA LTD.) 23 July 2015 (2015-07-23) description, paragraphs 30-57, and figures 2 and 4 | 1-5, 7-11, 13-20 |
| Y | US 2015204617 A1 (FUJIKURA LTD.) 23 July 2015 (2015-07-23) description, paragraphs 30-57, and figures 2 and 4 | 6, 12 |
| Y | US 5076352 A (THERMACORE INC.) 31 December 1991 (1991-12-31) description, column 1, line 60-column 2, line 30, and figure 2 | 6, 12 |
| A | JP 2018076989 A (FUJIKURA LTD.) 17 May 2018 (2018-05-17) entire document | 1-20 |
| A | JP 6049837 B1 (FUJIKURA LTD.) 21 December 2016 (2016-12-21) entire document | 1-20 |
| A | JP 2013002640 A (FUJIKURA LTD.) 07 January 2013 (2013-01-07) entire document | 1-20 |
| A | JP 2017141984 A (FUJIKURA LTD.) 17 August 2017 (2017-08-17) entire document | 1-20 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **19 September 2024** | **11 October 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| --- |
| **PCT/CN2024/110412** |

### C. DOCUMENTS CONSIDERED TO BE RELEVANT

| Category* | Citation of document, with indication, where appropriate, of the relevant passages | Relevant to claim No. |
| --- | --- | --- |
| A | TW M486751 U (ASIA VITAL COMPONENTS CO., LTD.) 21 September 2014 (2014-09-21) entire document | 1-20 |
| A | TW 201312073 A (FORCECON TECHNOLOGY CO., LTD.) 16 March 2013 (2013-03-16) entire document | 1-20 |
| A | CN 115823921 A (SUZHOU YUANQIAO PRECISION ELECTRONICS CO., LTD.) 21 March 2023 (2023-03-21) entire document | 1-20 |
| A | CN 213273898 U (CHENGDU AERONAUTIC POLYTECHNIC et al.) 25 May 2021 (2021-05-25) entire document | 1-20 |

**INTERNATIONAL SEARCH REPORT**
Information on patent family members

International application No.

**PCT/CN2024/110412**

| Patent document cited in search report | | | Publication date (day/month/year) | Patent family member(s) | | | Publication date (day/month/year) |
|---|---|---|---|---|---|---|---|
| US | 2015204617 | A1 | 23 July 2015 | JP | 5685656 | B1 | 18 March 2015 |
| | | | | JP | 2015135211 | A | 27 July 2015 |
| | | | | US | 9933212 | B2 | 03 April 2018 |
| US | 5076352 | A | 31 December 1991 | | None | | |
| JP | 2018076989 | A | 17 May 2018 | JP | 6694799 | B2 | 20 May 2020 |
| JP | 6049837 | B1 | 21 December 2016 | JP | 2017083074 | A | 18 May 2017 |
| JP | 2013002640 | A | 07 January 2013 | JP | 5902404 | B2 | 13 April 2016 |
| JP | 2017141984 | A | 17 August 2017 | | None | | |
| TW | M486751 | U | 21 September 2014 | | None | | |
| TW | 201312073 | A | 16 March 2013 | TWI | 458930 | B | 01 November 2014 |
| CN | 115823921 | A | 21 March 2023 | | None | | |
| CN | 213273898 | U | 25 May 2021 | | None | | |

Form PCT/ISA/210 (patent family annex) (July 2022)

**EP 4 726 315 A1**

**Patent documents cited in the description**

- CN 202311171404